Europäisches Patentamt

European Patent Office

Office européen des brevets

(11) Publication number: **0 211 618**
**B1**

(12) **EUROPEAN PATENT SPECIFICATION**

(45) Date of publication of patent specification: **18.07.90**

(21) Application number: **86305894.7**

(22) Date of filing: **31.07.86**

(51) Int. Cl.⁵: **H 01 L 23/04, H 01 L 23/14, H 01 L 23/10**

(30) Priority: **05.08.85 JP 171068/85**
**21.08.85 JP 181692/85**

(43) Date of publication of application:
**25.02.87 Bulletin 87/09**

(45) Publication of the grant of the patent:
**18.07.90 Bulletin 90/29**

(84) Designated Contracting States:
**DE GB**

(56) References cited:
**EP-A-0 081 992**
**EP-A-0 114 760**
**DE-A-3 401 984**
**PATENT ABSTRACTS OF JAPAN, vol. 9, no. 61 (E-303)1784r, 19th March 1985; & JP-A-59 198 741 (NIPPON GAKKI SEIZO K.K.) 10-11-1984**
**PATENT ABSTRACTS OF JAPAN, vol. 9, no. 3 (M-349)1726r, 9th January 1985; & JP-A-59 153 806 (TOSHIBA K.K.) 01-09-1984**

(54) Integrated circuit package.

(73) Proprietor: **HITACHI, LTD.**
**6, Kanda Surugadai 4-chome**
**Chiyoda-ku, Tokyo 100 (JP)**

(72) Inventor: **Tsuchiya, Masatoshi**
**9-6, Higashi-oonuma-cho 4-chome**
**Hitachi-shi Ibaraki 316 (JP)**
Inventor: **Ogihara, Satoru**
**15-7, Minami-kouya-cho 1-chome**
**Hitachi-shi Ibaraki 319-12 (JP)**
Inventor: **Kagohara, Hiromi**
**17-2, Moriyama-cho 2-chome**
**Hitachi-shi Ibaraki 316 (JP)**
Inventor: **Otsuka, Kanji**
**1074-38, Kohan 2-chome**
**Higashi-yamato-shi Tokyo 189 (JP)**
Inventor: **Oishi, Tomoji**
**Yuuhou-ryo, 20-3, Ayukawa-cho 6-chome**
**Hitachi-shi Ibaraki 316 (JP)**

(74) Representative: **Calderbank, Thomas Roger et al**
**MEWBURN ELLIS & CO. 2/3 Cursitor Street**
**London EC4A 1BQ (GB)**

Courier Press, Leamington Spa, England.

**Description**

The present invention relates to an integrated circuit package for use e.g. in electronic computers.

A known integrated circuit package consists of accommodating semiconductor elements, ends of lead pieces introduced from the exterior of the package and wires that electrically connect the semiconductor elements and the lead pieces together in a small airtight cell that is defined by an insulating substrate of a ceramic, a cap and a sealing glass. For instance, JP—A—59134852 entitled "Integrated Circuit Package" laid open on August 2, 1984 (corresponding to DE—A—3401984) exemplifies the use of a silicon carbide ceramic as an insulating substrate instead of the traditionally used alumina sintered product.

In such an integrated circuit package, however, cracks easily develop in a glass layer that seals the substrate and the cap as disclosed in the above publication.

To prevent the glass layer from being cracked, the above publication teaches the use of a cap that is composed of a ceramic having a coefficient of thermal expansion close to that of an insulating substrate composed of a silicon carbide ceramic.

The inventors of the present invention have prepared an integrated circuit package in which semiconductor elements were mounted on a silicon carbide substrate, ends of electric leads were connected to the semiconductor elements, portions where the leads were connected to the semiconductor elements were packaged with a sealing glass, and the electric leads passed to the exterior of the package through the glass. However, a problem was found in that the sealing glass cracks, particularly around the lead terminals. When this happens, the cell containing the semiconductor element communicates with the open air, and moisture contained in the open air enters into the cell so that the device may malfunction.

It is thought that the sealing glass is cracked by thermal stress produced by the lead material that has a large coefficient of thermal expansion.

In order to prevent the sealing glass from being cracked it has been considered that a lead material having a coefficient of thermal expansion that is in agreement with the coefficient of thermal expansion of the sealing glass should be used. However, the inventors of the present invention have established that when the package employs a silicon carbide ceramic as the substrate, the sealing glass is not prevented from being cracked even when the coefficient of thermal expansion of the lead material is brought into agreement with the coefficient of thermal expansion of the glass.

The inventors of the present invention have discovered that the sealing glass can be very effectively prevented from being cracked if the coefficient of thermal expansion of the lead material is set to be nearly equal to, or smaller than, the coefficient of thermal expansion of the substrate, instead of selecting the coefficient of thermal expansion of the lead material relying upon the coefficient of thermal expansion of the glass as a reference. The present invention is therefore based upon this discovery.

Based upon the above discovery, the present invention as defined in claim 1 restricts the coefficient of thermal expansion of the lead material in order to provide an integrated circuit packaging having increased stability and reliability. It proposes that the integrated circuit package comprises semiconductor elements mounted on an insulating substrate and leads introduced from the outside penetrating through a sealing glass such that the elements are accommodated in a small cell airtightly defined by the substrate, a cap and the sealing glass, and has the coefficient of thermal expansion of a lead material selected to be nearly equal to, or smaller than, the coefficient of thermal expansion of the substrate and, in practice, is restricted to be smaller than $40 \times 10^{-7}/°C$.

The integrated circuit package preferably has an insulating substrate composed of a silicon carbide ceramic, wherein the lead pieces are composed of an iron alloy which contains nickel and cobalt and which has a martensite transformation temperature of lower than −55°C.

The inventors of the present invention have found that one of the causes of cracks in the glass layer in the integrated circuit package, that has an insulating substrate composed of a silicon carbide ceramic, is that the glass layer receives the thermal stress occurring during cooling after sealing with glass is effected, or during a life test in which a completed package is subjected to thermal cycles.

In order that the glass layer does not receive the thermal stress, the inventors have reached the conclusion that the thermal expansion and contraction of the lead material should be brought to be nearly the same as the thermal expansion and contraction of the glass.

The effects of the present invention may be demonstrated by life tests in which the package is subjected to thermal cycles. It is found that the present invention may provide an integrated circuit package having improved reliability without cracks in the glass layer.

Embodiments of the invention will now be described in detail, by way of example, with reference to the accompanying drawings, in which:

Fig. 1 is a cross-sectional view of an integrated circuit package according to a first embodiment of the present invention;

Fig. 2 is a diagram showing the thermal expansion characteristics of the lead materials and the glass; and

Figs. 3 to 5 are cross-sectional views of integrated circuit packages according to other embodiments of the present invention.

The substrate employed in an embodiment of the present invention is a ceramic substrate with a coefficient of thermal expansion of from 35 to $40 \times 10^{-7}/°C$. Preferably, the substrate should be composed of a silicon carbide ceramic which contains at least one component selected from beryllium and a beryllium compound in an amount of 0.05 to 5% by weight reckoned as beryllium. The material for forming the cap has a coefficient of thermal expansion within a range of from 30 to 55 $\times$ $10^{-7}$/°C, preferably 35 to 50 $\times$ $10^{-7}$/°C, and preferably of mullite ceramic, silicon carbide ceramic, zircon ceramic or silicon nitride ceramic. The sealing glass is a low-melting glass having a coefficient of thermal expansion within a range of 30 (preferably 45) to 55 $\times$ $10^{-7}$/°C and preferably has a sealing temperature of not higher than 470°C. These limitations are imposed on the sealing temperature because of the reasons described below. When the semiconductor element is attached to the substrate, if the temperature of the sealing operation is higher than 470°C, aluminium or a like metal forming the electrode of the semiconductor may diffuse into the pn junction of the semiconductor to cause it to deteriorate. No glass is available that can be adhered at low temperatures and that has a coefficient of thermal expansion close to that of the silicon carbide ceramic. Therefore, attempts have been made to decrease the coefficient of thermal expansion by blending a lead borosilicate-type glass having a low melting point with lead titanate that has a negative coefficient of thermal expansion, or by blending a glass with a filler such as β-eucryptite. However, if the filler is blended in large amounts, the glass loses the fluidity. Therefore, the coefficient of thermal expansion of the glass is preferably limited to 45 to 55 $\times$ $10^{-7}$/°C.

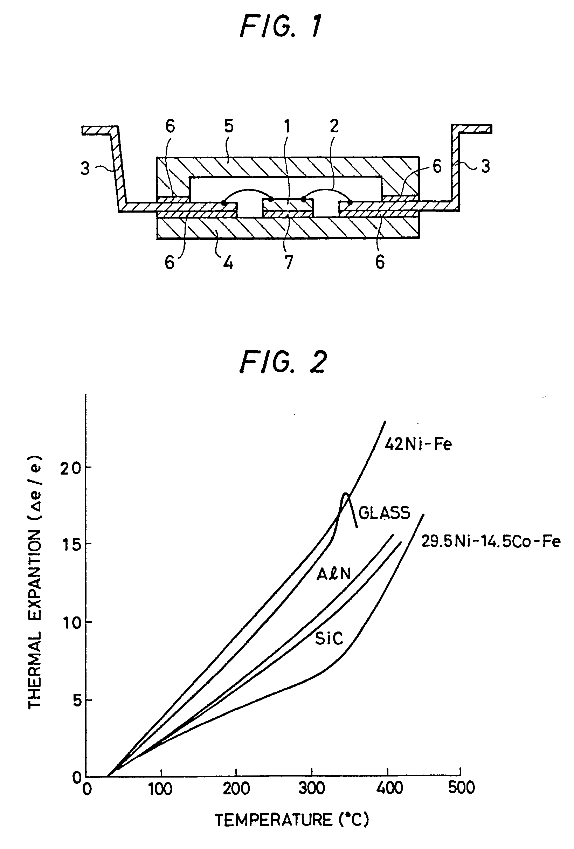

As described above, the sealing glass may easily be cracked and, particularly, the glass will be easily cracked around the lead terminals when the package is made of a glass through the heat-treatment using a silicon carbide ceramic substrate shown in Fig. 1, which is composed of the combination of the above-mentioned materials. According to the present invention as defined in claim 1, however, a package having excellent reliability that does not develop cracks in the sealing glass may be obtained by selecting the coefficient of thermal expansion of the lead material to be smaller than 40 $\times$ $10^{-7}$/°C which is nearly equal to, or smaller than, the coefficient of thermal expansion of the substrate. Thus, to prevent the development of cracks, the coefficient of thermal expansion of lead material is limited as described above, the lead material is sealed in the glass to bring the coefficient of thermal expansion of the sealing glass close to the coefficient of thermal expansion of the substrate, although the sealing glass has the coefficient of thermal expansion that is greater than that of the substrate.

An example of the lead material is Kovar (Ni-Co-Fe alloy). In particular, the Kovar should have a composition consisting of 28.5 to 30.0% by weight of nickel, 12.5 to 14% by weight of cobalt, less than 0.02% by weight of carbon, less than 0.2% by weight of silicon, less than 0.8% by weight of manganese, and the remainder being iron.

Next, individual parts of the integrated circuit package of the present invention will be described.

(A) Structure of the lead piece:

The lead pieces used in embodiments of the present invention may be composed of a material having a phase transition temperature of lower than −55°C and, in practice, having a martensite transformation temperature of lower than −55°C. In a life test, an integrated circuit package is usually subjected to thermal cycles of between −55°C and +150°C. Therefore, the lead piece must have a phase transition temperature lower than −55°C. Examples of materials having such a very low phase transition temperature and a small coefficient of thermal expansion may be iron alloys which contain nickel and cobalt. Of such iron alloys, an alloy which contains 29 to 31% by weight of nickel and 12.5 to 15% by weight of cobalt, has a coefficient of thermal expansion close to the coefficient of thermal expansion of the glass, and is best suited for the material of the lead pieces. It has been confirmed that a coefficient of thermal expansion smaller than 40 $\times$ $10^{-7}$/°C may be obtained if a melt of Fe-Ni-Co alloy having the above-mentioned composition is subjected to cold working of 10 to 60% followed by annealing at a temperature of 100° to 600°C to remove stress. In practice, an alloy of the above-mentioned composition may further contain less than 0.1% by weight of carbon, less than 0.5% by weight of silicon, and less than 0.5% by weight of manganese. Other impurities such as phosphorus and sulphur that unavoidably infiltrate during the step of melting may of course be contained in amounts to a degree that are usually contained in melting such alloys.

If the amounts of nickel and cobalt are smaller than the above-mentioned ranges, martensite is transformed when the alloy is cooled from the completely annealed state, and the coefficient of thermal expansion increases. If the amounts of nickel and cobalt are greater than the above-mentioned ranges, on the other hand, austenite is chemically stabilized and the transformation point of martensite decreases. However, the coefficient of thermal expansion increases beyond 40 $\times$ $10^{-7}$/°C. If the amount of cold working is less than 10%, the austenite is not stabilized. Depending upon the composition, furthermore, the coefficient of thermal expansion increases if the amount of cold working exceeds 60%. If the amount of cold working exceeds 90%, furthermore, there is formed a strain-induced martensite, which greatly increases the coefficient of thermal expansion. Preferably, the cold working should be 12 to 50%, so that the austenite is stabilized. To remove the stress, the annealing should be effected at a temperature lower than the recrystallization temperature of the material; i.e., the annealing should be effected preferably at 100°C to 600°C. If the annealing is effected at a temperature lower than 100°C, stress may not be removed sufficiently and the lead may be deformed when it is sealed with the glass. If annealed at a temperature in excess of 600°C, the austenite loses stability, and the martensite is easily transformed.

The allowable amounts of elements that are added as deoxidizing and desulphurising agents and elements that unavoidably infiltrate during the production are described below. Carbon that works as a powerful deoxidizing agent is necessary to increase the degree of purity of the material. However, the coefficient of thermal expansion increases with an increase in the amount of carbon. Therefore, the amount of carbon should not be greater than 0.1% by weight. Silicon is also used as a deoxidizing agent. However, increase in the amount of silicon causes the toughness to decrease, which results in the breakage of the leads. Therefore, the amounts of silicon should not be greater than 0.5% by weight. Manganese is used as a desulphurising agent. However, the coefficient of thermal expansion increases if the amount of manganese increases. Therefore, the amount of manganese should not be greater than 0.5% by weight. Phosphorus and sulphur deteriorate the tenacity of the material. Therefore, the total amount of phosphorus and sulphur should not be greater than 0.01% by weight.

Table 1 shows coefficients of thermal expansion of an Ni-Fe alloy and Ni-Co-Fe alloys and their phase transformation temperatures as found from the change in the electric resistance.

### Table 1

| Composition (% by weight) | Transformation temperature | Coefficient of thermal expansion $(\times 10^{-7}/°C)$ at 30° to 400°C |
|---|---|---|
| 42Ni-Fe | -196°C or lower | 48.9 |
| 29Ni-17Co-Fe | -196°C or lower | 44.5 |
| 29.5Ni-14.5Co-Fe | -150° ∿ -196°C | 32.6 |
| 30.5Ni-13.2Co-Fe | -100° ∿ -150°C | 37.4 |
| 29Ni-12Co-Fe | 0 ∿ -30°C | 41.2 |

Fig. 2 shows thermal expansion characteristics of the Ni-Co-Fe alloy containing 29.5% by weight of nickel and 14.5% by weight of cobalt, that is a lead material which may be used in the present invention, the Ni-Fe alloy containing 42% by weight of nickel shown for the purpose of comparison, and the glass. The Ni-Co-Fe alloy expands thermally less than the glass.

(B) Structure of the insulating substrate;

The insulating substrate is preferably composed of a silicon carbide ceramic. By using a silicon carbide ceramic instead of the conventional substrate composed of an alumina sintered product, the heat generated by the semiconductor elements can be radiated efficiently.

A substrate of silicon carbide ceramic can be produced by the sintering method that is usually carried out to produce moulded products of ceramic.

A preferred insulating substrate is composed of a silicon carbide ceramic composed chiefly of silicon carbide containing at least one component selected from beryllium and a beryllium compound in an amount of 0.05 to 5% by weight reckoned as beryllium, which is a sintered product having a relative density greater than 90% of the theoretical density. The coefficient of thermal expansion of such a sintered product ranges from 35 to $40 \times 10^{-7}/°C$, which is close to the coefficient of thermal expansion of silicon. Also, the sintered product has a thermal conductivity greater than 0.2 cal/cm.s.°C. The value 0.2 cal/cm.s.°C represents the lower limit of thermal conductivity that can be obtained, whilst maintaining good reproducibility when the silicon carbide ceramic is obtained by the sintering and without adversely affecting the electrically insulating property (resistivity of greater than $10^7$ ohms-cm) and the coefficient of thermal expansion. Furthermore, the above value is about four times greater than the thermal conductivity of known substrates composed of alumina ceramic. Moreover, the coefficient of thermal expansion is close to that of silicon used for making semiconductor elements. Therefore, when the semiconductor elements are joined to the substrate, small thermal stress is produced by the difference in the thermal expansion of the silicon elements and the substrate.

It is also possible to use a sintered product of aluminium nitride to obtain the substrates.

(C) Structure of the cap:

The cap for covering the semiconductor elements and wirings on the substrate should be composed of a material that has a coefficient of thermal expansion of 20 to $55 \times 10^{-7}/°C$ (preferably 20 to $50 \times 10^{-7}/°C$. Examples of such a material include silicon carbide ceramic, mullite ceramic, zircon ceramic, and silicon nitride ceramic. Using a cap material having the above-mentioned coefficient of thermal expansion, the

4

difference of expansion relative to the insulating substrate composed of silicon carbide can be reduced to at least one-third or smaller of the difference when conventional alumina ceramic (having a coefficient of thermal expansion of about $65 \times 10^{-7}/°C$) is used. Therefore, the thermal stress can be decreased correspondingly between the substrate and the cap.

(D) Structure of the sealing glass:

Ideally, the sealing glass should have a coefficient of thermal expansion close to that of the silicon carbide ceramic used for the substrate, i.e. should have a coefficient of thermal expansion from 30 to $55 \times 10^{-7}/°C$, and preferably from 40 to $55 \times 10^{-7}/°C$. Sealing with the glass is effected after the semiconductor elements are adhered onto the insulating substrate. Therefore, a glass having a high melting point is not desirable. It is desirable to select a glass with which the sealing can be effected at a temperature of 500°C or lower.

To satisfy these conditions, it is preferable to use a glass of the β-eucryptite type, lead titanium type, or of the lead borate type containing both of them.

According to the present invention as defined in claim 1, an integrated circuit package may be obtained that does not develop cracks in the sealing portion, that maintains high stability and reliability without permitting a deterioration in electric properties, and that radiates the heat efficiently, even when it is cooled from the sealing temperature down to room temperature or even when it is subjected to repetitive thermal cycles between −55°C and +150°C.

Examples

With reference to Fig. 1, a semiconductor element 1 is adhered by a metal soldering layer 7 onto a central portion on one surface of an insulating substrate 4 composed of a silicon carbide ceramic. Onto the same surface are further adhered a plurality of lead pieces 3 by a sealing glass layer 6. One set of ends of the lead pieces 3 are electrically connected to the semiconductor element via bonding wires 2. The other set of ends of the lead pieces 3 extend outwardly beyond the peripheral edge of the insulating substrate 4. The semiconductor element 1, bonding wires 2 and ends of the lead pieces 3 are enclosed by the insulating substrate 4 and a cap 5. Gaps between the cap 5, the insulating substrate 4 and the lead pieces 3 are sealed so as to be airtight by the sealing glass layer 6.

Packages of the above-mentioned structure are also prepared using different cap materials, glass materials and lead materials. The substrate is composed of a silicon carbide ceramic having a coefficient of thermal expansion from 35 to 40 $\times 10^{-7}/°C$. It is particularly desirable to use a silicon carbide ceramic which contains 0.05 to 5% by weight of beryllium and which exhibits a resistivity greater than $10^8$ ohms-cm, a thermal conductivity of 0.2 to 0.7 cal/cm.s.°C, a bending strength of greater than $3 \times 10^8$ Nm$^{-2}$ (30 kgf/mm$^2$), and the coefficient of thermal expansion of 35 $\times 10^{-7}/°C$.

This package is produced by a method described below. To join the semiconductor elements onto the silicon carbide substrate, a gold paste is first printed and is baked. Then, the metal soldering layer 7 is formed on the substrate. The sealing glass 6 is printed onto the silicon carbide substrate and is baked to adhere the glass onto the substrate. The lead pieces 3 are placed on the upper surface of the sealing glass layer 6 that is heated at, for example, 450° to 480°C (which is higher than the softening temperature of the glass) in order to adhere the lead pieces thereto. The semiconductor element 1 is placed on the metal soldering layer 7 on the substrate, and the metal soldering layer 7 is heated at 350° to 450°C so that the semiconductor element adheres thereto. The semiconductor element is electrically connected to the lead pieces via wires 2. Next, the cap material 5, with the sealing glass 6, is placed thereon and is heated at 445° to 460°C to seal it with the glass. The integrated circuit package is thus prepared. After sealing, the package is subjected to 20 thermal cycles between −55° and +150°C. Then, the package is subjected to a helium leakage test to measure the amount of leakage and to evaluate whether the package is acceptable or not.

Table 2 shows combinations of the materials and the evaluated results of the packages.

Table 2

| No. | Lead material | | Glass material | | Cap material | | Evaluation |
|---|---|---|---|---|---|---|---|
| | Designation | Coefficient of thermal expansion (x $10^{-7}$/°C) | Designation | Coefficient of thermal expansion (x $10^{-7}$/°C) | Designation | Coefficient of thermal expansion (x $10^{-7}$/°C) | |
| 1 | A | 43 | I | 51 | Mullite | 48 | NG |
| 2 | B | 41 | " | " | " | " | NG |
| 3 | C | 39 | " | " | " | " | OK |
| 4 | D | 35 | " | " | " | " | OK |
| 5 | E | 28 | " | " | " | " | OK |
| 6 | A | 43 | II | 48 | " | " | NG |
| 7 | C | 38 | " | " | " | " | OK |
| 8 | D | 35 | " | " | " | " | OK |
| 9 | E | 28 | " | " | " | " | OK |
| 10 | F | 30 | " | " | " | " | OK |
| 11 | A | 43 | III | 53 | " | " | NG |
| 12 | B | 41 | " | " | " | " | NG |

EP 0 211 618 B1

Table 2 (cont'd)

| No. | Lead material | | Glass material | | Cap material | | Evalua-tion |
| --- | --- | --- | --- | --- | --- | --- | --- |
| | Designa-tion | Coefficient of thermal expansion $(x\ 10^{-7}/°C)$ | Designa-tion | Coefficient of thermal expansion $(x\ 10^{-7}/°C)$ | Designa-tion | Coefficient of thermal expansion $(x\ 10^{-7}/°C)$ | |
| 13 | C | 39 | III | 53 | Mullite | 48 | OK |
| 14 | D | 35 | " | " | " | " | OK |
| 15 | F | 30 | I | 51 | Zircon | 42 | OK |
| 16 | E | 28 | " | " | " | " | OK |
| 17 | F | 30 | " | " | Silicon nitride | 35 | OK |
| 18 | E | 28 | " | " | " | " | OK |
| 19 | F | 30 | " | " | Alumina | 65 | NG |

EP 0 211 618 B1

Leakage of helium took place in packages Nos. 1, 2, 6, 11 and 12 that employed lead materials having coefficients of thermal expansion of $41 \times 10^{-7}/°C$ and $43 \times 10^{-7}/°C$. Leakage of helium did not take place in the packages that employed lead materials having coefficients of thermal expansion of smaller than $39 \times 10^{-7}/°C$. In the packages that employed a cap composed of alumina, cracks developed in the glass even though the lead materials possessed small coefficients of thermal expansion.

Like Table 2, Table 3 evaluates packages consisting of different materials relying upon the helium leakage test.

Table 3

| No. | Lead material | | Glass material | | Cap material | | Evaluation |
| --- | Designation | Coefficient of thermal expansion $(\times 10^{-7}/°C)$ | Designation | Coefficient of thermal expansion $(\times 10^{-7}/°C)$ | Designation | Coefficient of thermal expansion $(\times 10^{-7}/°C)$ | |
| --- | --- | --- | --- | --- | --- | --- | --- |
| 20 | F | 30 | IV | 53 | Alumina | 65 | NG |
| 21 | A | 43 | " | " | Mullite | 48 | NG |
| 22 | B | 41 | " | " | " | " | NG |
| 23 | C | 38 | " | " | " | " | OK |
| 24 | D | 35 | " | " | " | " | OK |
| 25 | E | 28 | " | " | " | " | OK |
| 26 | A | 43 | V | 56 | " | " | NG |
| 27 | B | 41 | " | " | " | " | NG |
| 28 | C | 38 | " | " | " | " | NG |
| 29 | D | 35 | " | " | " | " | NG |
| 30 | E | 28 | " | " | " | " | NG |
| 31 | A | 43 | IV | 53 | Zircon | 42 | NG |

EP 0 211 618 B1

Table 3 (cont'd)

| No. | Lead material | | Glass material | | Cap material | | Evalua-tion |
|---|---|---|---|---|---|---|---|
| | Designa-tion | Coefficient of thermal expansion $(x\ 10^{-7}/°C)$ | Designa-tion | Coefficient of thermal expansion $(x\ 10^{-7}/°C)$ | Designa-tion | Coefficient of thermal expansion $(x\ 10^{-7}/°C)$ | |
| 32 | B | 41 | IV | 53 | Zircon | 42 | NG |
| 33 | C | 38 | " | " | " | " | OK |
| 34 | D | 35 | " | " | " | " | OK |
| 35 | E | 28 | " | " | " | " | OK |
| 36 | E | 28 | " | " | Alumina | 65 | NG |

EP 0 211 618 B1

Packages employing a cap composed of alumina developed cracks in the sealing glass and were not acceptable (Nos. 20 and 36). Helium did not leak in the packages that employed lead materials having coefficients of thermal expansion smaller than $38 \times 10^{-7}/°C$, glass material having a coefficient of thermal expansion of $53 \times 10^{-7}/°C$ and a cap composed of mullite or ziron (Nos. 23, 24, 25, 33, 34 and 35). However, leakage of helium took place in the packages that employed lead materials having coefficients of thermal expansion greater than $41 \times 10^{-7}/°C$ and glass material having a coefficient of thermal expansion of $56 \times 10^{-7}/°C$ (Nos. 21, 22, 26, 27, 28, 29, 30, 31 and 32).

Thus, integrated circuit packages having high reliability without developing cracks in the sealing glass can be obtained if use is made of a substrate composed of a silicon carbide ceramic, a glass material having a coefficient of thermal expansion of 45 to $55 \times 10^{-7}/°C$, a cap material having a coefficient of thermal expansion of 35 to $50 \times 10^{-7}/°C$, and a lead frame material having a coefficient of thermal expansion of smaller than $40 \times 10^{-7}/°C$.

The cap is composed of a mullite ceramic having a coefficient of thermal expansion (40 to $55 \times 10^{-7}/°C$) close to that of the silicon carbide ceramic, or a silicon carbide ceramic (25 to $35 \times 10^{-7}/°C$). The sealing glass has a coefficient of thermal expansion ranging from 40 to $55 \times 10^{-7}/°C$), close to the coefficients of thermal expansion of the silicon carbide ceramic that forms the substrate and of the cap material. From the standpoint of thermal resistance of the semiconductor element, sealing with glass should be effected at a temperature of not higher than 500°C. Examples of the glass having a low sealing temperature and a small coefficient of thermal expansion include β-eucryptite, lead titanate and a glass of the lead borate type containing β-eucryptite and lead titanate, that can be used as sealing glasses in the present invention.

The lead pieces are preferably composed of the Ni-Co-Fe alloy having a coefficient of thermal expansion of smaller than $40 \times 10^{-7}/°C$ at room temperature to 400°C, and having a martensite transformation temperature of lower than −55°C. To prepare the lead pieces, iron, nickel and cobalt are blended together in required amounts and are melted under vacuum. The melt is then hot-rolled and is thereafter repetitively subjected to cold rolling and annealing to obtain a plate 0.18 mm thick. The plate is annealed again and is cold-rolled to have a thickness of 0.15 mm. Then, the plate is annealed at about 400° to 500°C to remove strain. The lead frame is prepared from the plate thus obtained, in order to fabricate the integrated circuit package that is shown in Fig. 1. A reliability test over a temperature range of from −55°C to +150°C proves that no leakage takes place at all in the glass-sealed portions.

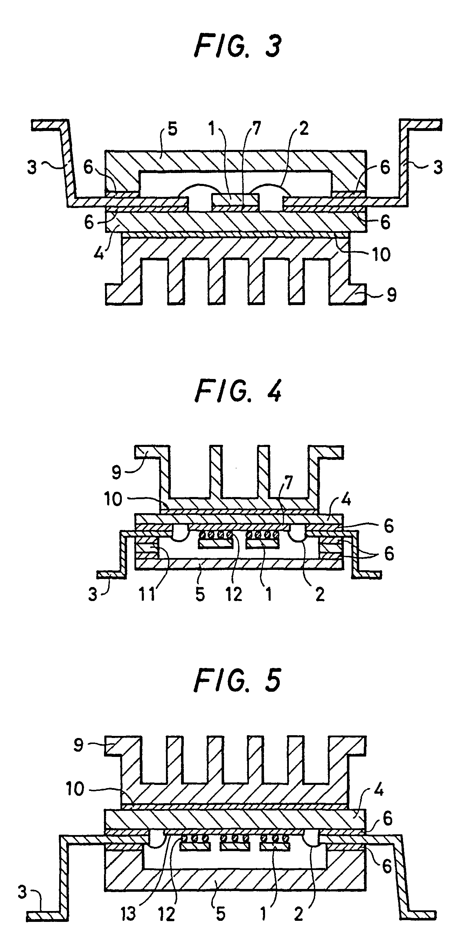

Fig. 3 illustrates an embodiment in which cooling fins 9 are adhered at 10 onto the surface of the substrate 4 to utilize effectively the high thermal conductivity of the silicon carbide ceramic. In this case, the thermal resistance is 7.7°C/w between the semiconductor element and the surface of the substrate.

Fig. 4 illustrates an embodiment in which many semiconductor elements are mounted on a silicon carbide ceramic substrate. In this package, a silicon wiring substrate 7 is joined onto the silicon carbide substrate 4, and semiconductor elements 1 are joined thereon via a binder 12. Even in this case, the lead material must have a small coefficient of thermal expansion. Here, reference numeral 11 denotes a flange.

Fig. 5 shows a package in which a wiring board composed of a copper conductor and an insulating material is placed on the silicon carbide ceramic substrate, and semiconductor elements are joined thereon. Even in this package, the lead material must have a small coefficient of thermal expansion. Reference numeral 13 denotes wiring.

According to the present invention as described above, no cracks develop in the sealing glass even when the integrated circuit package employing the substrate composed of silicon carbide or aluminium nitride ceramic is exposed to a test of predetermined thermal cycles.

According to the present invention, furthermore, a highly reliable integrated circuit package may be obtained which does not develop cracks in the glass-sealed portions even when it is cooled from the glass-sealing temperature down to room temperature or even when it is subjected to a life test of thermal cycles ranging in temperature from −55° to +150°C.

## Claims

1. An integrated circuit package in which at least one semiconductor element (1) is mounted on an insulating substrate (4), and is accommodated in an airtight cell defined by the substrate (4), a cap (5) and sealing glass (6), ends of lead pieces (3) extending into the cell and being connected by wires (2) to element(s) (1), wherein the insulating substrate (4) is of a ceramic having a coefficient of thermal expansion from 35 to $40 \times 10^{-7}/°C$ and a high thermal conductivity, the cap (5) is composed of a ceramic material having a coefficient of thermal expansion of from 20 to $55 \times 10^{-7}/°C$, the sealing glass has a coefficient of thermal expansion from 30 to $55 \times 10^{-7}/°C$, and characterized in that the lead pieces are composed of an alloy having a coefficient of thermal expansion smaller than $40 \times 10^{-7}/°C$.

2. An integrated circuit package according to claim 1, characterized in that the lead pieces (3) are of a Ni-Co-Fe alloy.

3. An integrated circuit package according to claim 1, or claim 2, characterized in that the lead pieces (3) are of an iron alloy which contains nickel and cobalt and has a martensite transformation temperature of less than −55°C.

4. An integrated circuit package according to claim 3, characterized in that the iron alloy has a composition consisting of 29 to 31% by weight of nickel, 12.5 to 15.5% by weight of cobalt, and the remainder being substantially iron.

5. An integrated circuit package according to claim 4, characterized in that the iron alloy is annealed at a temperature ranging from 100° to 600°C to remove the stress.

6. An integrated circuit package according to any one of the preceding claims, characterized in that the sealing glass (6) is a low-melting glass that permits the sealing operation to be effected at a temperature less than 470°C.

7. An integrated circuit package according to any one of the preceding claims, characterized in that the substrate (4) is a sintered product of silicon carbide.

8. An integrated circuit package according to claim 7, characterized in that the sintered product has a composition which contains at least either one of beryllium or a beryllium compound in an amount of 0.05 to 5% by weight on the basis of beryllium, and the remainder being substantially silicon carbide.

9. An integrated circuit package according to any one of the preceding claims, characterized in that the cap (5) is any one of mullite ceramic, silicon carbide ceramic zircon ceramic, or silicon nitride ceramic.

10. An integrated circuit package according to any one of the preceding claims, characterized in that the glass (6) is any one of β-eucryptite, lead titanate-type glass or lead borate-type glass.

**Patentansprüche**

1. Integrierte Schaltungspackung, bei der mindestens ein Halbleiterbauelement (1) auf einem isolierenden Substrat (4) montiert und in einer von dem Substrat (4), einer Kappe (5) und Dichtglas (6) gebildeten luftdichten Zelle untergebracht ist, wobei Enden von Leiterteilen (3) in die Zelle hineinführen und über Drähte (2) mit dem bzw. den Bauelementen (1) verbunden sind, wobei das isolierende Substrat (4) aus einer Keramik mit einem Wärmeausdehnungskoeffizient von 35 bis $40 \times 10^{-7}/°C$ und hoher Wärmeleitfähigkeit besteht, wobei die Kappe (5) aus keramischem Material mit einem Wärmeausdehnungskoeffizient von 20 bis $55 \times 10^{-7}/°C$ besteht und wobei das Dichtglas einem Wärmeausdehnungskoeffizient von 30 bis $55 \times 10^{-7}/°C$ aufweist, dadurch gekennzeichnet, daß die Leiterteile aus einer Legierung mit einem Wärmeausdehnungskoeffizient von unter $40 \times 10^{-7}/°C$ bestehen.

2. Integrierte Schaltungspackung nach Anspruch 1, dadurch gekennzeichnet, daß die Leiterteile (3) aus einer Ni-Co-Fe-Legierung bestehen.

3. Integrierte Schaltungspackung nach Anspruch 1 oder 2, dadurch gekennzeichnet, daß die Leiterteile (3) aus einer Nickel und Kobalt enthaltenden Eisenlegierung mit einer Martensit-Übergangstemperatur von weniger als −55°C bestehen.

4. Integrierte Schaltungspackung nach Anspruch 3, dadurch gekennzeichnet, daß die Eisenlegierung eine Zusammensetzung aufweist, die aus 29 bis 31 Gew.-% Nickel, 12,5 bis 15,5 Gew.-% Kobalt, Rest im wesentlichen Eisen, besteht.

5. Integrierte Schaltungspackung nach Anspruch 4, dadurch gekennzeichnet, daß die Eisenlegierung zur Beseitigung von Spannungen bei einer Temperatur im Bereich von 100 bis 600°C geglüht ist.

6. Integrierte Schaltungspackung nach einem der vorhergehenden Ansprüche, dadurch gekennzeichnet, daß das Dichtglas (6) ein tiefschmelzendes Glas ist, das die Durchführung des Dichtungsvorgangs bei einer Temperatur unterhalb von 470°C gestattet.

7. Integrierte Schaltungspackung nach einem der vorhergehenden Ansprüche, dadurch gekennzeichnet, daß das Substrat (4) ein gesintertes Siliciumcarbid-Teil ist.

8. Integrierte Schaltungspackung nach Anspruch 7, dadurch gekennzeichnet, daß das gesinterte Teil eine Zusammensetzung aufweist, die mindestens Beryllium oder eine Berylliumverbindung in einer Menge von 0,05 bis 5 Gew.-%, bezogen auf Beryllium, Rest im wesentlichen Siliciumcarbid, enthält.

9. Integrierte Schaltungspackung nach einem der vorhergehenden Ansprüche, dadurch gekennzeichnet, daß die Kappe (5) aus einer Mullit-, Siliciumcarbid-, Zirkon- oder Siliciumnitrid-Keramik besteht.

10. Integrierte Schaltungspackung nach einem der vorhergehenden Ansprüche, dadurch gekennzeichnet, daß das Glas (6) ein β-Eukryptit-, Bleititanat- oder Bleiborat-Glas ist.

**Revendications**

1. Empaquetage pour circuit intégré dans lequel au moins un élément semiconducteur (1) est monté sur un substrat isolant (4) et est reçu dans une cellule étanche à l'air définie par le substrat (4), un capuchon (5) et un verre d'étanchéité (6), des extrémités de pièces conductrices (3) s'étendant dans la cellule et étant connectées par des fils (2) au(x) élément(s) (1), le substrat isolant (4) étant en une céramique ayant un coefficient de dilatation thermique de 35 à $40 \times 10^{-7}/°C$ et une haute conductivité thermique, le capuchon (5) se composant d'une céramique ayant un coefficient de dilatation thermique de 20 à $55 \times 10^{-7}/°C$, le verre d'étanchéité ayant un coefficient de dilatation thermique de 35 à $55 \times 10^{-7}/°C$ et caractérisé en ce que les pièces conductrices sont formées d'un alliage ayant un coefficient de dilatation thermique plus petit que $40 \times 10^{-7}/°C$.

2. Empaquetage pour circuit intégré selon la revendication 1, caractérisé en ce que les pièces conductrices (3) sont en un alliage Ni-Co-Fe.

3. Empaquetage pour circuit intégré selon la revendication 1 ou 2, caractérisé en ce que les pièces conductrices (3) sont en un alliage de fer qui contient du nickel et du cobalt et a une température de transformation en martensite de moins de −55°C.

4. Empaquetage pour circuit intégré selon la revendication 3, caractérisé en ce que l'alliage de fer a une composition consistant en 29 à 31% en poids de nickel, 12,5 à 15,5% en poids de cobalt, le reste étant sensiblement du fer.

5. Empaquetage pour circuit intégré selon la revendication 4, caractérisé en ce que l'alliage de fer est recuit à une température comprise entre 100°C et 600°C pour supprimer la contrainte.

6. Empaquetage pour circuit intégré selon l'une quelconque des revendications précédentes, caractérisé en ce que le verre d'étanchéité (6) est un verre à faible point de fusion qui permet d'effectuer l'opération d'étanchéification à une température inférieure à 470°C.

7. Empaquetage pour circuit intégré selon l'une quelconque des revendications précédentes, caractérisé en ce que le substrat (4) est un produit fritté de carbure de silicium.

8. Empaquetage pour circuit intégré selon la revendication 7, caractérisé en ce que le produit fritté a une composition qui contient au moins soit l'un de béryllium ou d'un composé de béryllium en une quantité de 0,05 à 5% en poids sur la base du béryllium, le reste étant sensiblement du carbure de silicium.

9. Empaquetage pour circuit intégré selon l'une quelconque des revendications précédentes, caractérisé en ce que le capuchon (5) est pris parmi une céramique de mullite, une céramique de carbure de silicium, une céramique de zircone ou une céramique de nitrure de silicium.

10. Empaquetage pour circuit intégré selon l'une quelconque des revendications précédentes, caractérisé en ce que le verre (6) est pris parmi du verre du type β-eucryptite, du verre du type titanate de plomb ou du verre du type borate de plomb.

EP 0 211 618 B1

## FIG. 1

## FIG. 2

## FIG. 3

## FIG. 4

## FIG. 5